Europäisches Patentamt

European Patent Office

Office européen des brevets

(11) Numéro de publication: **0 368 775**
**A1**

## (12) DEMANDE DE BREVET EUROPEEN

(21) Numéro de dépôt: 89440120.7

(22) Date de dépôt: **07.11.89**

(51) Int. Cl.⁵: **H05K 3/26, B08B 3/02**

(30) Priorité: **07.11.88 FR 8815471**

(43) Date de publication de la demande:
**16.05.90 Bulletin 90/20**

(84) Etats contractants désignés:
**AT BE CH DE ES FR GB GR IT LI LU NL SE**

(71) Demandeur: **VAL, S.à.r.l.**
**22 rue de la Mairie Valescourt**
**F-60130 Saint Just en Chaussée (Oise)(FR)**

(72) Inventeur: **Val, Bernard**
**22 rue de la Mairie Valescourt**
**F-60130 Saint Just en Chaussée (Oise)(FR)**

(74) Mandataire: **Lepage, Jean-Pierre**
**Cabinet Lepage & Aubertin Innovations et**
**Prestations 23/25, rue Nicolas Leblanc B.P.**
**1069**
**F-59011 Lille Cédex 1 (Nord)(FR)**

(54) **Machine de nettoyage d'objets.**

(57) L'invention est relative à une machine de nettoyage d'objets, tels que des composants électriques et/ou électroniques, notamment disposés sur un support de type "circuit imprimé" ou similaire.

La machine (1) de nettoyage permet de faire subir aux dits objets un nettoyage puis un séchage et comporte :
- deux enceintes de traitement (3, 4) fermées indépendantes, la première étant équipée de moyens de nettoyage (7) des dits objets, la deuxième étant dotée de moyens de séchage (8) des dits objets nettoyés,
- au moins un panier support (5) des dits objets à nettoyer, apte à être placé dans la première et/ou la deuxième enceintes,
- des moyens de transfert (6) du dit panier support (5) d'une enceinte vers l'autre et/ou inversement (3, 4).

Fig. 2

L'invention est relative à une machine de nettoyage d'objets, tels que des composants électriques et/ou électroniques notamment disposés sur un support de type "circuit imprimé" ou similaire. Elle trouvera notamment son application dans le domaine de la construction d'équipements électriques et/ou électroniques.

Dans ce domaine, de nombreuses machines, appareils ou dispositifs utilisent de plus en plus pour leur fonctionnement des circuits de composants électriques et/ou électroniques. Ces derniers sont généralement disposés et câblés sur des supports de type "circuits imprimés" ou similaires.

Une normalisation européenne a fait que ces circuits électriques ou électroniques, de plus en plus utilisés, sont produits industriellement.

En effet, on connait des machines de réalisation en série de ces cartes électroniques qui permettent de minimiser la main d'oeuvre et de réduire le coût de revient. Sur ces circuits imprimés ou similaires, les composants sont généralement soudés, ces soudures étant effectuées automatiquement, par exemple par une technique dite de "soudure à la vague".

Lors de ces soudures, on utilise un flux résineux qui favorise la soudure mais qui doit être nettoyé après soudure et avant utilisation de la carte de composants électriques et/ou électroniques.

Pour ce, on connait des machines de nettoyage de telles cartes de composants électriques et/ou électroniques qui utilisent le traitement au fréon dans lesquelles du fréon liquide est vaporisé à une température voisine de 40 °C, cette vaporisation répartissant le fréon sur l'ensemble de la carte à traiter et détruisant notamment la résine qui a été utilisée pour la soudure.

L'utilisation d'une telle technique est dans certains cas satisfaisante mais n'est pas sans présenter de nombreux inconvénients. Un premier inconvénient est de type écologique car vis-à-vis de l'environnement, il est connu que le fréon détruit l'ozone de l'atmosphère.

Sur un plan technique, il est quelquefois indispensable de monter sur les cartes des composants électriques et/ou électroniques qui ne résistent pas au traitement au fréon. Dans ce cas, les dits composants doivent être montés ultérieurement au nettoyage à la carte qui doit alors faire l'objet d'une reprise de câblage suivie d'une reprise de nettoyage manuel.

Le but de la présente invention est de proposer une machine de nettoyage d'objets, tels que composants électriques et/ou électroniques notamment disposés sur un support de type "circuits imprimés" ou similaires, dans laquelle on fait subir aux dits objets un traitement qui soit autre que le traitement au fréon afin de pallier les inconvénients de cette technique.

Un des buts de la présente invention est de proposer une telle machine de nettoyage d'objets qui permette de réaliser séquentiellement leur nettoyage, notamment à l'eau déminéralisée, puis leur séchage sans porter préjudice aux dits objets.

Un autre but de la présente invention est de proposer une machine de nettoyage qui soit compacte et qui permette le traitement de petites et moyennes séries dans un temps admissible.

A cet égard, grâce à la structure de la présente invention, le séchage est réalisé en temps masqué c'est-à-dire que la machine permet le séchage d'une série de cartes préalablement nettoyées pendant qu'une autre série est en phase de nettoyage.

Un autre but de la présente invention est de proposer une machine de nettoyage qui ne soit pas dégradante pour l'environnement et l'atmosphère et qui évite la détérioration des composants électriques et/ou électroniques en cours de traitement.

Ainsi, on évitera toute reprise de câblage et de nettoyage postérieure, le câblage pouvant être terminé en une seule étape et le nettoyage autorisé sur l'ensemble des composants.

D'autres buts et avantages de la présente invention apparaitront au cours de la description qui va suivre qui n'est cependant donnée qu'à titre indicatif et qui n'a pas pour but de la limiter.

Selon la présente invention, la machine de nettoyage d'objets, tels que des composants électriques et/ou électroniques notamment disposés sur un support de type "circuits imprimés" ou similaires, dans laquelle on fait subir aux dits objets un nettoyage et un séchage, est caractérisée par le fait qu'elle comporte :
- deux enceintes de traitement fermées indépendantes, la première étant équipée de moyens de nettoyage des dits objets, la deuxième étant dotée de moyens de séchage des dits objets nettoyés,
- au moins un panier support des dits objets à nettoyer, apte à être placé dans la première et/ou la seconde enceinte,
- des moyens de transfert du dit panier support d'une enceinte vers l'autre et/ou inversement.

La présente invention sera mieux comprise à la lecture de la description suivante accompagnée des dessins en annexe qui en font partie intégrante.

La figure 1 montre une vue en perspective de la machine de nettoyage d'objets de la présente invention.

La figure 2 montre une vue en perspective de face de la machine de nettoyage d'objets de la présente invention en position ouverte.

La figure 3 montre une vue schématique de profil de la machine de la présente invention en position ouverte illustrant l'enceinte de nettoyage.

La figure 4 montre une vue schématique de profil de la cuve de séchage en position fermée.

La figure 5 illustre une vue de dessus selon l'axe V-V de la figure 3, le panier support d'objets étant ôté.

La figure 6 montre une vue schématique d'un détail de la machine de la présente invention permettant de rendre l'ouverture des enceintes de nettoyage et de séchage possible.

La présente invention vise une machine de nettoyage d'objets. Elle trouvera notamment son application pour le nettoyage des composants électriques et/ou électroniques notamment disposés sur un support de type "circuits imprimés" ou similaires.

En effet, elle permettra le nettoyage et le séchage de telles cartes équipées de composants après leur câblage sans pour cela être préjudiciables à l'environnement ni aux composants. Contrairement à la technique connue de nettoyage de tels circuits, utilisant la vaporisation du fréon pour détruire la résine du flux résineux utilisé lors de la soudure des composants sur le circuit imprimé, la machine de nettoyage de la présente invention utilise un nettoyage, notamment à l'eau déminéralisée, suivi d'un séchage ne 35 portant pas préjudice aux composants.

Le nettoyage est réalisé par aspersion d'eau pendant un temps préétabli en fonction des dimensions et des nécessités du nettoyage, temps pouvant être compris entre 2 et 15 minutes par exemple.

Ensuite, on réalise un séchage des objets ainsi nettoyés en utilisant de l'air réchauffé brassé pour augmenter l'efficacité du séchage. La phase de séchage est également dépendante des conditions de nettoyage et peut varier par exemple de 2 à 15 minutes à une température allant de 30 à 80 $^\circ$ C.

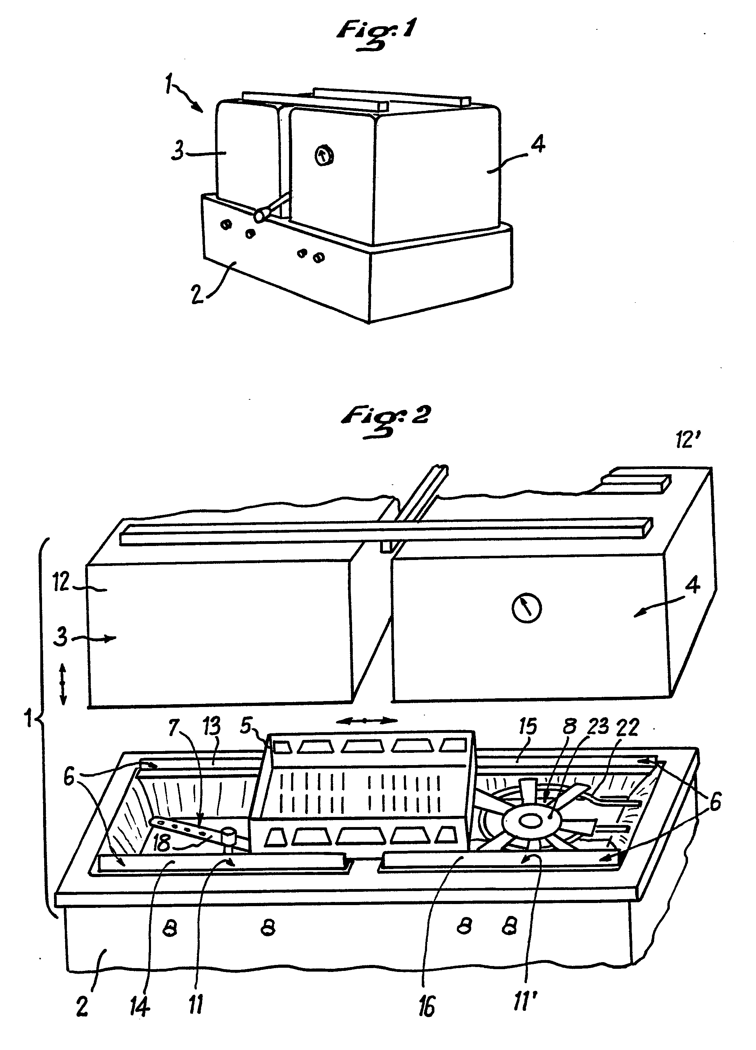

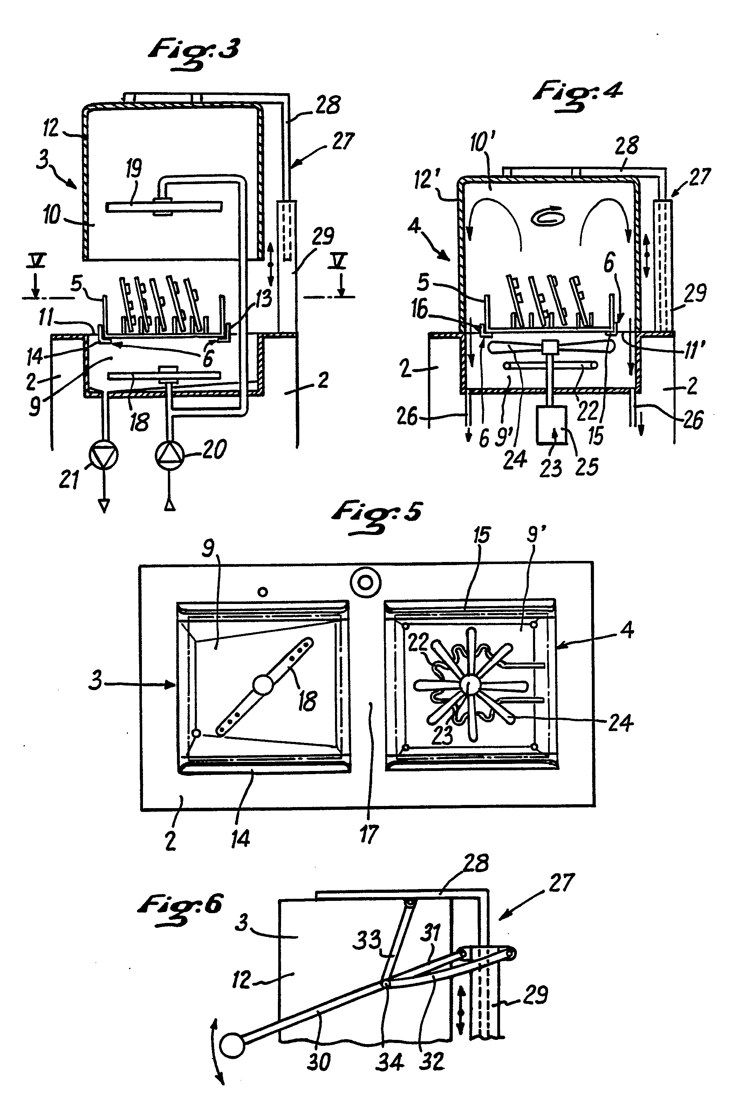

Ces étapes peuvent être mises en oeuvre dans la machine de nettoyage 1 telle qu'un mode de réalisation est illustré aux figures 1 et 2.

Elle est constituée d'un bâti 2 supportant deux enceintes de traitement 3 et 4, fermées et indépendantes l'une de l'autre, constituant respectivement une enceinte de nettoyage 3 et une enceinte de séchage 4.

A cet égard, la première enceinte 3 est équipée de moyens 7 de nettoyage des dits objets, tandis que la deuxième enceinte de séchage 4 est quant à elle équipée de moyens 8 de séchage des dits objets nettoyés. Ces moyens seront décrits en détail ultérieurement.

En outre, la machine 1 comporte au moins un panier support 5 des dits objets à nettoyer, apte à être placé dans la première et/ou seconde enceintes 3, 4, ainsi que des moyens de transfert 6 du dit panier support 5 d'une enceinte 3 ou 4 vers l'autre, ou inversement.

Les figures 3 et 4 montrent plus en détail, mais de façon schématique, la réalisation respective des enceintes de nettoyage 3 et de séchage 4.

Chacune des dites enceintes fermées et indépendantes 3, 4 est constituée par une cuve définissant une cavité inférieure 9, 9' et une cavité supérieure 10, 10' délimitées par un plan de pose 11, 11' du dit panier support 5 des objets à nettoyer.

Plus précisément, dans le bâti fixe 2, on prévoit les dites cavités inférieures 9, 9' et on dispose au-dessus de ces dites cavités inférieures deux cloches amovibles 12, 12', afin de définir les dites cuves de nettoyage 3 et de séchage 4.

Dans l'exemple représenté aux figures, il est à noter que les dites cuves 3 et 4 sont avantageusement disposées côte à côte. En ce qui concerne leurs structures, elles pourront être réalisées en métal, tel qu'en acier inoxydable par exemple, ou en matériau synthétique moulé.

Pour ce qui est des moyens de transfert 6, ils sont constitués au moins par un chemin de roulement et/ou de glissement autorisant le positionnement du dit panier support 5 d'objets à l'intérieur de l'enceinte de nettoyage 3, puis à l'intérieur de l'enceinte de séchage 4, par translation du panier 5 manuelle voire mécanisée.

Dans la réalisation illustrée sur les figures, ce chemin de roulement et/ou de glissement est avantageusement constitué par des cornières en L 13 à 16.

Aussi, le chemin de roulement est discontinu pour permettre la fermeture des enceintes 3, 4 et autoriser une certaine étanchéité selon les cas pendant la phase de traitement.

Néanmoins, les cornières 13 à 16 seront disposées sensiblement dans un même plan pour autoriser le transfert par simple glissement du panier 5. Au niveau de la partie centrale 17 comprise entre les cuves 3 et 4, les cornières seront avantageusement évasées pour favoriser le guidage du panier et faciliter son introduction soit sur les glissières 13, 14 de l'enceinte 3, soit sur les glissières 15, 16 de l'enceinte 4.

Dans ce cas, les moyens de transfert 6 ainsi constitués définissent avantageusement le dit plan de pose 11 ou 11'. Néanmoins, il pourrait être envisagé sans pour autant sortir du cadre de la présente invention de prévoir le plan de pose à un autre niveau dans les dites cuves 3 et 4.

Il est à noter que les cornières 13, 14, 15, 16 peuvent être remplacées par deux cornières sur toute la longueur; dans ce cas, il faut échancrer les enceintes 3 et 4 pour assurer la fermeture.

En ce qui concerne les moyens de nettoyage 7, ils sont notamment constitués par au moins un bras de nettoyage 18 rotatif, apte à asperger les dits objets à nettoyer qui y sont assujettis, au moins avec de l'eau déminéralisée, placé sous les objets dans la cavité inférieure 9.

Pour augmenter l'efficacité du nettoyage, on prévoira avantageusement un deuxième bras de nettoyage 19 disposé dans la cavité supérieure 10.

Il est à noter qu'on pourrait également envisager de prévoir une machine présentant une enceinte de nettoyage équipée uniquement d'un bras d'aspersion 19 prévu dans la cavité supérieure 10; ou encore tout autre dispositif d'aspersion statique ou rotatif connu de l'Homme du Métier.

En ce qui concerne la réalisation des bras rotatifs de nettoyage 18, 19, ils seront avantageusement constitués par des bras de type "lave-vaisselle" alimentés par une pompe 20 ou par des tubes non munis de trous. Par ailleurs, les eaux usées seront évacuées à la partie basse de la cavité inférieure 9 par exemple par une pompe de vidange 21.

Pour ce qui est des moyens de séchage 8, ils seront avantageusement constitués notamment par au moins une résistance de chauffage 22, surmontée de moyens 23 de brassage de l'air chauffé. De tels moyens sont notamment illustrés aux figures 2, 4 et 5.

Sur ces différentes figures, les moyens de séchage 8 sont disposés dans la cavité inférieure 9' de la cuve de séchage 4 sous le panier support 5 afin de faciliter l'échange thermique et de favoriser le séchage.

La résistance de chauffage est notamment du type immersible afin de pouvoir résister à l'humidité et constituée par un serpentin circulaire ou ondulé, comme le montrent respectivement les figures 2 et 5.

Les moyens de brassage 23 sont constitués par un ventilateur 24 mû par un organe moteur 25. Les moyens de brassage 23 à 25 seront prévus tels que l'air contenu dans le volume de l'enceinte 4 soit brassé violemment ce qui soufflera l'eau et la vapeur d'eau vers les parois de l'enceinte 4; l'eau et la condensation s'évacueront par des orifices 26 prévus à la partie inférieure de la cavité 9' de la cuve de séchage 4. La circulation d'air et l'évacuation des gouttelettes sont notamment illustrées par les flèches sur la figure 4.

A titre d'exemple, on obtient de bons résultats pour une enceinte d'un volume sensiblement voisin de 0,220 mm3 en élevant la température à 50 °C à l'aide d'une résistance régulée de 3.000 watts et en utilisant un ventilateur dont l'hélice présente un diamètre sensiblement égal à 300 mm et tourne à une vitesse de l'ordre de 3.000 tours/mn.

Cela étant, l'enceinte de nettoyage aura des dimensions sensiblement voisines de celle de séchage qui correspondent également à une bonne efficacité des dits moyens d'aspersion rotatifs 18, 19. Un traitement des cartes à l'eau froide ou tiède est réalisé dans de telles conditions efficacement dans un cycle d'environ 3 à 10 minutes.

En outre, l'adjonction au cours des cycles de nettoyage d'un produit saponifiant, au moyen d'une pompe doseuse, ou autre dispositif, permettra de nettoyer également des cartes soudées avec des flux résineux.

Par ailleurs, on équipera avantageusement la machine de nettoyage de la présente invention d'un deuxième panier support d'objets afin que, lorsque l'on traite un premier panier dans l'enceinte de nettoyage 3, on puisse sécher en temps masqué un panier déjà traité dans l'enceinte de séchage 4.

Une telle machine dans cette configuration permet le traitement de 24 cartes par cycle, ce qui permet le traitement par heure d'environ 120 cartes.

Cela étant, les traitements seront réalisés à poste fixe, ce qui permet de rendre compact la machine malgré une cadence élevée de traitement. Pour autoriser la manutention des paniers et pour permettre le transfert des paniers et d'une cuve vers l'autre, les dites cloches 12, 12' amovibles, formant les dites cavités supérieures 10, 10' des enceintes 3, 4 sont portées par des moyens de manoeuvre 27 de celles-ci par rapport au bâti 2.

Ces moyens sont illustrés à titre d'exemple aux figures 3, 4 et 6. Ils sont notamment constitués par une potence supérieure 28 sur la flèche de laquelle sont solidarisées les parties supérieures des cuves 12, 12'; et d'un fût 29 solidarisé quant à lui sur le bâti 2.

La potence 28 et le fût 29 sont prévus tels que la potence puisse coulisser dans le fût, ces deux éléments étant soumis à l'action d'une poignée de commande 30 particulièrement illustrée à la figure 6.

Cette poignée de commande 30 est constituée par différents leviers 31, 32, 33, articulés entre eux en 34, et articulés au niveau du sommet du fût pour les leviers 31 et 32 et au niveau de la potence 28 pour ce qui est du levier 33.

Ainsi, une manoeuvre vers le haut ou vers le bas de la poignée de commande permettra une translation verticale de la cloche respectivement vers le haut ou vers le bas.

A titre de moyens de manoeuvre 27, on pourrait utiliser des vérins hydrauliques, par exemple.

Pour ce qui est du fonctionnement semi-automatique ou automatique, la commande et le déroulement des cycles sont assurés par un automate programmable ou par une centrale électronique par exemple.

Cela étant, il est à noter que dans certains cas il est préconisé de nettoyer le flux résineux avec de l'eau à laquelle on a ajouté un additif du type saponifiant. La présente invention pourra bien entendu autoriser un tel nettoyage.

Dans ce cas, la machine comportera avantageusement des moyens pour autoriser l'introduction de tels produits additifs pendant le cycle de lavage, par exemple par l'intermédiaire d'une pompe auxiliaire.

En fonction du type de produit et en fonction de sa quantité dans l'eau, il pourra être intéressant de prévoir une motorisation, notamment à vitesse variable, des deux bras de lavage pour pallier la cavitation éventuelle de la pompe de lavage lors de la présence de mousse.

Dans ce cas, les organes moteurs seront avantageusement placés à l'extérieur de la cuve et seront reliés aux bras de lavage via un joint tournant.

Pour ce qui est du bras supérieur, contrairement à l'illustration de la figure 3, le bras de lavage 19 sera fixé à même la partie supérieure de la cloche 12, et l'amenée d'eau se fera par une canalisation souple extérieure et par joints tournants.

Une telle disposition permettra donc de nettoyer des cartes à l'aide d'un agent saponifiant sans que la mousse provoquée éventuellement ne fasse caviter la pompe d'aspersion. En outre, l'utilisation de la vitesse variable de cette motorisation sera avantageuse pour provoquer un balayage lent des cartes afin de nettoyer des zones complexes engendrées par la disposition des composants électroniques.

Naturellement, d'autres mises en oeuvre de la présente invention, à la portée de l'Homme de l'Art, auraient pu être envisagées sans pour autant sortir du cadre de celle-ci. Par exemple, on pourrait tout à fait mécaniser le système de relevage des cloches, tel que montré à la figure 6, en utilisant un ou plusieurs vérins pneumatiques.

De même, l'Homme de l'Art pourra à l'aide d'un jeu d'électrovannes faire en sorte que l'on utilise qu'une seule pompe pour le lavage et la vidange.

## Revendications

1. Machine de nettoyage d'objets, tels que des composants électriques et/ou électroniques notamment disposés sur un support de type "circuit imprimé" ou similaire, dans laquelle on fait subir aux dits objets un nettoyage et un séchage, caractérisée par le fait qu'elle comporte :
- deux enceintes de traitement (3, 4) fermées, indépendantes, la première enceinte (3) étant équipée de moyens (7) de nettoyage des dits objets, la deuxième enceinte (4) étant équipée de moyens (8) de séchage des dits objets nettoyés,
- au moins un panier support (5) des dits objets à nettoyer, apte à être placé dans la première et/ou deuxième enceinte,

- des moyens de transfert (6) du panier support (5) d'une enceinte vers l'autre et/ou inversement (3, 4).

2. Machine de nettoyage selon la revendication 1, caractérisée par le fait que les dites enceintes (3, 4) fermées et indépendantes, sont constituées chacune par une cuve définissant une cavité inférieure (9, 9') et une cavité supérieure (10, 10') délimitées par un plan de pose (11, 11') du dit panier (5) support des dits objets à nettoyer.

3. Machine de nettoyage selon la revendication 2, caractérisée par le fait que les cuves (3, 4) sont constituées d'une part par un bâti fixe (2) dans lequel les dites cavités inférieures (9, 9') sont prévues, et d'autre part par deux cloches (12, 12'), amovibles, formant les dites cavités supérieures (10, 10'), les dites cloches (12, 12') étant portées par des moyens de manoeuvre (30-34) par rapport au bâti (2).

4. Machine de nettoyage selon l'une quelconque des revendications 2 ou 3, caractérisée par le fait que les dites cuves (3, 4) sont disposées côte à côte.

5. Machine selon la revendication 1, caractérisée par le fait que les moyens de transfert (6) sont constitués au moins par un chemin de roulement et/ou de glissement (13-16) autorisant le positionnement du dit panier support (5) d'objets à l'intérieur de l'enceinte de nettoyage (3) puis à l'intérieur de l'enceinte de séchage (4).

6. Machine de nettoyage selon la revendication 2, caractérisée par le fait que les dits moyens de transfert (6) définissent le dit plan de pose (11, 1').

7. Machine de nettoyage selon la revendication 2, caractérisée par le fait que les moyens de nettoyage (7) sont constitués par au moins un bras de nettoyage (18 ou 19) rotatif, apte à asperger les dits objets qui y sont assujettis au moins avec de l'eau déminéralisée, le dit bras (18 ou 19) étant placé dans la cavité supérieure (10) ou inférieure (9).

8. Machine de nettoyage selon la revendication 7, caractérisée par le fait que les moyens de nettoyage (7) comportent deux bras d'aspersion (18, 19) l'un disposé au-dessus, l'autre en-dessous des objets à nettoyer.

9. Machine de nettoyage selon la revendication 1, caractérisée par le fait que les moyens de séchage (8) sont constitués par au moins une résistance de chauffage (22) surmontée de moyens (23) de brassage de l'air chauffé.

10. Machine de nettoyage selon la revendication 2, caractérisée par le fait que les dits moyens de séchage (8) sont disposés dans la cavité inférieure (9') de la cuve de séchage (4).

EP 0 368 775 A1

*Fig.1*

*Fig.2*

Fig:3

Fig:4

Fig:5

Fig:6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | DE-A- 515 141 (BRETON) <br> * Page 1, ligne 51 - page 2, ligne 9; figures 1-4 * | 1,5 | H 05 K 3/26 <br> B 08 B 3/02 |
| Y | | 2-4 | |
| Y | FR-A-2 308 340 (SOCIETE CIDELCEM) <br> * Page 2, lignes 9-19; page 3, lignes 8-37; page 6, lignes 22-25 * | 2-4 | |
| A | | 6,9,10 | |
| A | US-A-4 730 630 (RANFT) <br> * Résumé; figure 1 * | 7,8 | |
| A | US-A-3 498 303 (EAVES) <br> * Colonne 3, ligne 49 - colonne 4, ligne 55 * | 1,2,4-10 | |
| X | DE-A- 625 942 (BITZER) <br> * Page 1, ligne 57 - page 2, ligne 17 * | 1 | |
| A | GB-A-2 084 865 (EASIFORM ENGINEERING LTD) | | **DOMAINES TECHNIQUES RECHERCHES (Int. Cl.5)** <br><br> H 05 K <br> B 08 B <br> A 47 L |

Le présent rapport a été établi pour toutes les revendications

| Lieu de la recherche | Date d'achèvement de la recherche | Examinateur |
|---|---|---|
| LA HAYE | 12-02-1990 | MES L.A. |